# FASCICULE DE BREVET EUROPEEN

(11) **EP 0 395 487 B1**
(45) Date de publication et mention de la délivrance du brevet: **13.07.1994**
(21) Numéro de dépôt: 90401096.4
(22) Date de dépôt: 24.04.1990
(51) Int. Cl.: H01L 31/024, H01L 31/02, G01J 5/06

(54) **Système de mesure constitué d'un circuit de détection d'un rayonnement, d'un circuit de lecture et d'un support tel qu'un doigt froid de cryostat**
Messvorrichtung, die aus einer Erkennungsschaltung von Strahlung aus einem Träger und einem kalten Finger aus Kryostat besteht
Measuring system consisting of a radiation detection circuit and a support such as a cold finger of a cryostat

(30) Priorité: 28.04.1989 FR 8905711
(43) Date de publication de la demande: 31.10.1990
(73) Titulaire: COMMISSARIAT A L'ENERGIE ATOMIQUE, 75015 Paris Cédex 15 (FR)
(72) Inventeur: Ouvrier-Buffet, Jean-Louis, F-74320 Sevrier (FR); Ravetto, Michel, F-38170 Seyssinet Pariset (FR)
(74) Mandataire: Dubois-Chabert, Guy

(56) Documents cités:
- EP-A- 0 058 645
- EP-A- 0 136 687
- EP-A- 0 213 421
- WO-A-87/01448

## Description

L'invention se rapporte à un système de mesure constitué en particulier d'un circuit de détection d'un rayonnement, d'un circuit de lecture et d'un support tel qu'un doigt froid de cryostat.

La technique d'assemblage connue jusqu'à présent consiste à coller sur une face d'extrémité du doigt froid une plaque porteuse de pistes électriques de connexion, puis à coller sur la plaque le circuit de lecture après l'avoir soudé au circuit de détection au moyen de plots métalliques tels que des billes d'indium dont certains sont utilisés également pour assurer les connexions électriques entre les deux circuits.

On installe ensuite des fils conducteurs entre les pistes de la plaque et les emplacements de connexion du circuit de lecture d'une part, les lignes électriques fixées sur le doigt froid d'autre part. La transmission des informations originaires du circuit de détection vers des moyens d'enregistrement et d'exploitation est alors assurée.

Cette méthode est peu intéressante car les collages impliquent des difficultés d'alignement et de parallélisme corrects des circuits et l'installation des fils est une opération délicate et longue.

Ces étapes et donc les inconvénients qui leur sont liés sont éliminés en ayant recours à l'invention.

Le circuit de détection est encore soudé au circuit de lecture par des plots métalliques mais le système comprend en outre un couvercle fixé au support et délimitant une cavité avec lui, la cavité contenant les circuits, le couvercle étant muni de pistes conductrices électriques, le circuit de lecture étant soudé au couvercle par des plots métalliques dont certains au moins constituent des connexions électriques et contactent les pistes conductrices, le couvercle comprenant une fenêtre transparente en face de laquelle est disposé le circuit de détection.

Le support présente avantageusement un creux central contenant le circuit de lecture et constituant au moins partiellement la cavité, ainsi qu'une couronne entourant le creux et entaillée de rainures rayonnantes en face des pistes de connexion électrique. Les rainures pourront alors contenir des connecteurs souples aux extrémités de lignes électriques, fixées au support et venant contacter des pistes de connexion électrique respectives.

L'invention va maintenant être décrite plus en détail à l'aide des figures suivantes annexées à titre illustratif et nullement limitatif d'une réalisation de l'invention :

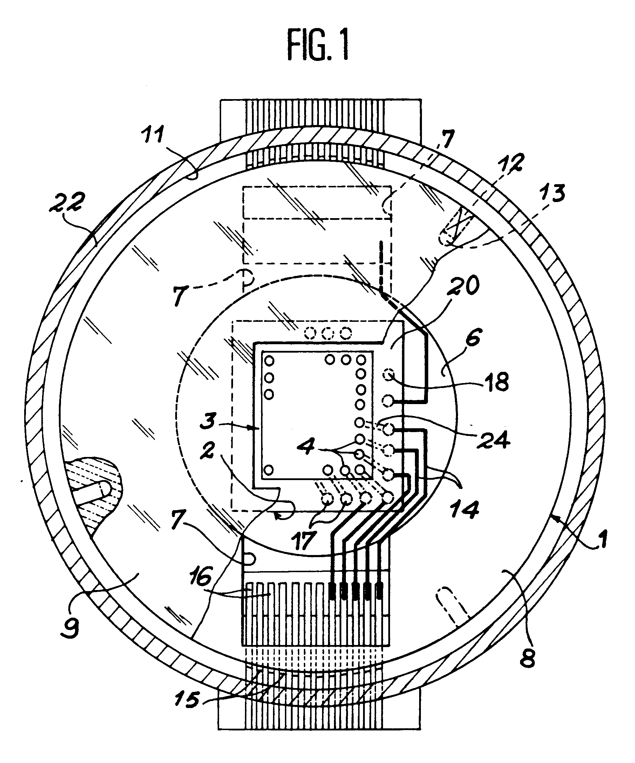

- la figure 1 représente une vue de face du support et du couvercle dans leur plan d'assemblage ; et

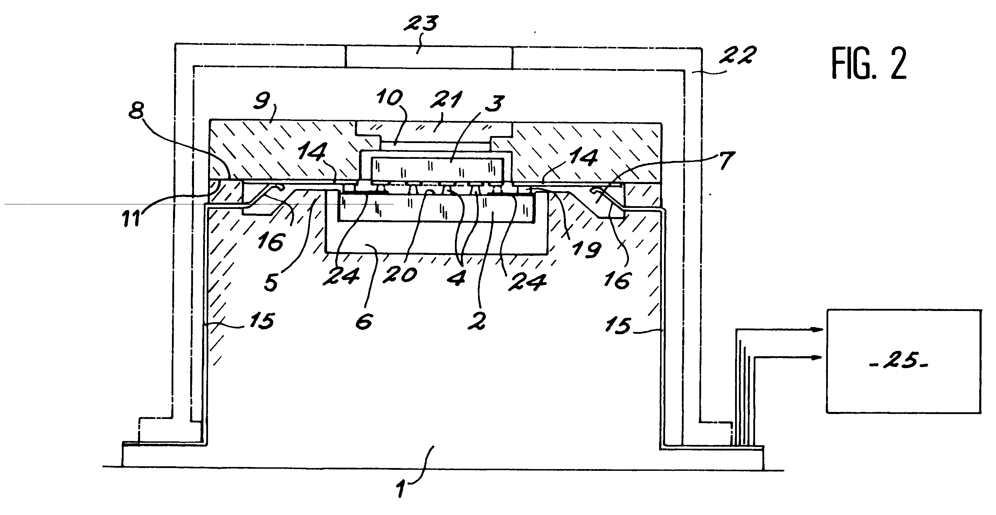

- la figure 2 représente une vue en coupe axiale de l'invention.

Sur ces figures, le doigt froid, le circuit de lecture et le circuit photosensible de détection sont désignés par les références 1, 2 et 3. Des billes d'indium 4 relient en les soudant le circuit de lecture 2 et le circuit de détection 3 ; certaines de ces billes 4 servent de connexions électriques entre les deux circuits.

Dans la réalisation illustrée de l'invention, l'extrémité du doigt froid 1 est façonnée de manière à présenter une couronne périphérique 5 entourant un creux central 6 et entaillée de rainures rayonnantes 7, ici au nombre de deux, entre le creux central 6 et le pourtour du doigt froid 1.

La couronne 5 présente une face supérieure plane 8 destinée à servir d'appui à un couvercle 9 en forme de couronne, traversé de part en part par une fenêtre centrale 10, couvercle 9 dont la face inférieure plane 11 s'appuie sur la surface supérieure 8 extérieure aux rainures du doigt froid 1. Des ergots de centrage 12 se dressent au-dessus de la surface supérieure 8 et s'emboîtent dans des logements correspondants 13 établis sur le couvercle 9, qui peut ainsi être assemblé dans une position bien déterminée par rapport au doigt froid 1.

Une partie de la face inférieure 11 du couvercle 9 porte des pistes de connexion électrique 14 réparties en groupes de façon à venir en face des rainures rayonnantes 7 quand le couvercle 9 et le doigt froid 1 sont assemblés. Le doigt froid 1 porte sur sa surface extérieure des lignes électriques 15 qui lui sont fixées et qui aboutissent à des connecteurs électriques 16 élastiques fixés au fond des rainures rayonnantes 7 du doigt froid 1. Quand l'assemblage est réalisé, l'extrémité libre de chaque connecteur 16 vient toucher une des pistes de connexion électrique 14 et est légèrement déformée.

Les pistes métalliques de connexion 14 s'écartent à proximité de la fenêtre 10 et aboutissent à des surfaces mouillantes 17 respectives qui, avec d'autres surfaces mouillantes isolées 18, entourent la fenêtre 10 sur la face inférieure 11.

Ces surfaces mouillantes 17 et 18 sont destinées à permettre l'adhérence de billes d'indium supplémentaires 19 qui adhèrent également à des surfaces mouillantes de répartition identique établies sur la face 20 du circuit intégré 2 qui porte déjà les billes d'indium 4 de liaison au circuit de détection 3. On obtient donc une disposition où le circuit de lecture 2 n'est maintenu en place que par les billes d'indium supplémentaires 19 et où son autre face n'a de contact direct avec aucune autre pièce, contrairement à la technique antérieure où cette face était collée. Le circuit de lecture 2 est en fait contenu dans le creux central 6, alors que le circuit de détection 3 est sans contact direct avec le couvercle 9 et est contenu dans la fenêtre 10. Le creux central 6 et la fenêtre 10 constituent ensemble une cavité qui peut être fermée en disposant un filtre 21 -facultatif- sur la fenêtre 10.

Les informations provenant du circuit de détection 3 sont donc transmises aux lignes électriques 15 par les billes d'indium 4, des pistes de connexion électrique 24 installées sur le circuit de lecture 2, les billes d'indium supplémentaires 19, les pistes de connexion électrique 14 et les connecteurs 16.

L'ensemble du système est disposé dans un cryostat où il est protégé du milieu extérieur par un écran 22 muni d'une fenêtre transparente 23 en face du circuit de détection 3.

La disposition des éléments du système de mesure permet un montage facile et un gain d'espace puisque les circuits 2 et 3 sont logés à l'intérieur d'une cavité. Un alignement et un parallélisme des deux circuits 2 et 3 avec le doigt froid 1 sont facilement obtenus en utilisant des techniques connues telles que, par exemple, celle exposée dans la demande de brevet internationale 87 01 509. Dans le cas présent, on pose le circuit de lecture 2 sur une sole chauffante, le circuit de détection 3 sur le circuit de lecture 2 et le couvercle 9 sur le circuit de lecture 2. Les billes d'indium 4 et 19 ont été préalablement soudées au circuit de lecture 2 dans une étape préliminaire de fusion puis de refroidissement et de resolidification. Une nouvelle fusion des billes d'indium 4 et 19 les fait s'étaler sur les surfaces mouillantes du circuit de détection 3 et du couvercle 9. Les poids de ces deux pièces, ainsi que les forces de tension superficielle régnant dans les billes fondues, déterminent les distances du circuit de détection 3 et du couvercle 9 au circuit de lecture 2. Un parallélisme excellent peut être obtenu avec des conditions géométriques appropriées, notamment si la répartition des poids est uniforme sur les billes 4 et 19. Les forces de tension superficielle assurent également l'alignement des surfaces mouillantes du circuit de lecture 2 avec celles du circuit de lecture 3 et du couvercle 9 en déplaçant horizontalement ces deux dernières pièces, comme il est expliqué dans le fascicule de la demande précitée.

Les billes d'indium 4 et 19 sont ensuite laissées refroidir jusqu'à ce qu'elles se resolidifient. L'assemblage est complété en enduisant de colle la surface supérieure 8 du doigt froid 1 et en appuyant le couvercle 9 sur cette surface supérieure 8 à l'aide d'une presse. Un excellent parallélisme peut être obtenu entre le couvercle 9 et la face supérieure 8 du doigt froid 1 car on peut appuyer une face d'extrémité plane de la presse sur la surface supérieure plane du couvercle 9.

Le collage peut être remplacé par un soudage ; la presse est alors équipée d'un enroulement chauffant le métal d'apport.

L'invention peut encore être mise en oeuvre de bien des manières différentes, avec des supports tels que le doigt froid 1 et des couvercles 9 de formes différentes, de même qu'avec des plots métalliques de liaison de composition chimique différente. Il est possible de choisir le métal des billes 4 et 19 parmi l'indium et ses alliages, les alliages de plomb et d'étain, le métal ou l'alliage des billes 4 pouvant être différent de celui des billes 19. Le circuit de détection 3 peut capter selon le cas de l'infrarouge, de l'ultraviolet, de la lumière visible ou des rayonnements ionisants en particulier.

## Revendications

1. Système de mesure constitué d'un circuit de détection (3) d'un rayonnement, d'un circuit de lecture (2) soudé au circuit de détection (3) par des plots métalliques (4) dont certains au moins constituent des connexions électriques, et un support tel qu'un doigt froid (1) de cryostat, caractérisé en ce qu'il comprend en outre un couvercle (9) fixé au support (1) et délimitant une cavité (6 et 10) avec lui, la cavité contenant les circuits (2, 3), le couvercle (9) étant muni de pistes conductrices électriques (14), le circuit de lecture (2) étant soudé au couvercle (9) par d'autres plots métalliques (19) dont certains au moins constituent des connexions électriques et contactent les pistes conductrices (14), le couvercle comprenant une fenêtre transparente (10) en face de laquelle est disposé le circuit de détection (3).

2. Système de mesure selon la revendication 1, caractérisé en ce que le couvercle (9) et le support (1) présentent des surfaces planes d'appui (8, 11) et des emboîtements de centrage (12, 13).

3. Système de mesure selon l'une quelconque des revendications 1 ou 2, caractérisé en ce que le support (1) présente un creux central (6) contenant le circuit de lecture (2) et constituant au moins partiellement la cavité ainsi qu'une couronne (5) entourant le creux (6) et entaillée de rainures rayonnantes (7) en face des pistes conductrices électriques (14).

4. Système de mesure selon la revendication 3, caractérisé en ce que les rainures (7) contiennent des extrémités de connexion souples (16) de lignes électriques (15) fixées au support (1), les extrémités de connexion (16) venant contacter des pistes conductrices électriques (14) respectives.

## Claims

1. Measuring system constituted by a radiation detection circuit (3), a reading circuit (2) welded to the detection circuit (3) by metal members (4), some of which constitute electrical connections, and a support such as a cryostat cold, finger (1), characterized in that it also comprises a cover (9) fixed to the support (1) and defining therewith a cavity (6,10), the latter containing the circuits (2,3), the cover (9) being provided with electrical conductive tracks (14), the reading circuit (2) being welded to the cover (9) by other metal members (19), at least some of these constituting the electrical connections and contacting the conductive tracks (14), the cover having a transparent window (10) in front of which is positioned the detection circuit (3).

2. Measuring system according to claim 1, characterized in that the cover (9) and the support (1) have planar bearing surfaces (8,11) and centring fitting means (12,13).

3. Measuring system according to claims 1 or 2, characterized in that the support (1) has a central hollow (6) containing the reading circuit (2) and at least partly constituting the cavity, as well as a ring (5) surrounding the hollow (6) and provided with radiating grooves (7) facing electric conductive tracks (14).

4. Measuring system according to claim 3, characterized in that the grooves (7) contain the flexible connecting ends (16) of electric lines (15) fixed to support (1), the ends (16) contacting the respective electric conductive tracks (14).

## Patentansprüche

1. Meßvorrichtung, bestehend aus einer Erkennungsschaltung (3) einer Strahlung, einer Leseschaltung (2), mit der Erkennungsschaltung verlötet mittels metallischen Lötstiften (4), von denen zumindest einige elektrische Verbindungen bilden, und einem Träger, wie etwa einem kalten Kryostatfinger (1),
**dadurch gekennzeichnet,**
daß sie außerdem einen Deckel (9) umfaßt, befestigt am Träger (1) und mit ihm einen Hohlraum (6 und 10) bildend, wobei der Hohlraum Schaltungen (2, 3) enthält, der Deckel (9) versehen ist mit elektrischen Leiterbahnen (14), die Leseschaltung (2) mit dem Deckel (9) verlötet ist durch weitere metallische Lötstifte (19), von denen wenigstens einige elektrische Verbindungen bilden und die Leiterbahnen (14) berühren, wobei der Deckel ein transparentes Fenster (10) enthält, vor dem die Erkennungsschaltung (3) angeordnet ist.

2. Meßvorrichtung nach Anspruch 1, dadurch gekennzeichnet, daß der Deckel (9) und der Träger (1) ebene Auflageflächen (8, 11) aufweisen und Zentrierungsführungen (12, 13).

3. Meßvorrichtung nach einem der Ansprüche 1 oder 2, dadurch gekennzeichnet, daß der Träger (1) eine zentrale Vertiefung (6) aufweist, die die Leseschaltung (2) enthält und wenigstens partiell den Hohlraum bildet, sowie eine Einfassung (5), die die Vertiefung (6) umgibt und in die abstrahlende bzw. sich strahlenförmig ausbreitende Nuten (7) eingeschnitten sind, gegenüber den elektrischen Leiterbahnen (14).

4. Meßvorrichtung nach Anspruch 3, dadurch gekennzeichnet, daß die Nuten (7) biegsame Verbindungsenden (16) von elektrischen Leitungen (15) enthalten, befestigt am Träger (1), wobei die Verbindungsenden (16) die jeweiligen elektrischen Leiterbahnen (14) berühren.
